# EUROPÄISCHE PATENTSCHRIFT

(11) **EP 1 913 612 B1**
(45) Veröffentlichungstag und Bekanntmachung des Hinweises auf die Patenterteilung: **18.05.2011**
(21) Anmeldenummer: 06776588.3
(22) Anmeldetag: 03.08.2006
(51) Int. Cl.: H01H 3/12, H03K 17/96

(54) **BEDIENELEMENT FÜR EIN KRAFTFAHRZEUG**
CONTROL ELEMENT FOR A MOTOR VEHICLE
ELEMENT DE COMMANDE POUR VEHICULE AUTOMOBILE

(30) Priorität: 03.08.2005 DE 102005036386
(43) Veröffentlichungstag der Anmeldung: 23.04.2008
(73) Patentinhaber: Preh GmbH, 97616 Bad Neustadt a. d. Saale (DE)
(72) Erfinder: JEITNER, Martin, 97645 Ostheim (DE); KRAMLICH, Andreas, 97424 Schweinfurt (DE); KRAUS, Peter, 97493 Bergreinfeld (DE); GESSNER, Volker, 97616 Salz (DE)
(74) Vertreter: Bauer, Wulf
(86) Internationale Anmeldenummer: PCT/EP2006/007690
(87) Internationale Veröffentlichungsnummer: WO 2007/014780

(56) Entgegenhaltungen:
- EP-A- 1 635 366
- EP-A1- 0 780 865
- DE-A1- 3 910 977
- DE-A1- 19 946 471
- DE-C1- 3 906 859
- DE-U1- 20 311 127
- FR-A1- 2 183 712

## Beschreibung

Die Erfindung betrifft ein Bedienelement, insbesondere einen Druckknopf, für ein Kraftfahrzeug bestehend zumindest aus einem auf kapazitiver Basis arbeitenden, berührungssensitiven Druckknopf und einem Gehäuse, wobei der Druckknopf im Gehäuse verschiebbar befestig ist.

Es ist bekannt, Tasten oder Bedienelement mit kapazitiven Elementen auszuführen, so dass bei einer Berührung der Taste mittels einer Auswerteelektronik eine mit der Taste verbundene Funktion auswählbar und/oder betätigbar ist. Beispielhaft ist in der DE 203 11 127 U ein berührungssensitiver Taster auf kapazitiver Basis als Eingabemöglichkeit bei Computersystemen oder elektronischen Geräten beschrieben. Hierbei wird auf eine Trägerplatte rückseitig eine Punktausleuchtungseinheit für die Tastenfläche in Form eines selbstleuchtenden Displays aufgebracht und frontseitig eine kapazitiv berührungssensitive Eingabemöglichkeit als Tastfläche angeordnet.

Eine weitere berührungssensitive Taste ist in der EP 0 780 865 beschrieben. Beschrieben ist eine Vorrichtung mit durch kapazitive Wirkung sensitiver Taste zum Erfassen des Vorhandenseins eines Elementes durch eine elektrisch isolierende Platte hindurch, wobei die Taste von einer Leiterplatte getragen ist, die im Wesentlichen parallel zu der Platte und elektronisch mit einer auf der Leiterplatte angeordneten elektronischen Erfassungsschaltung verbunden ist. Gebildet wird eine Elektrode dieser elektrischen Baugruppe aus einer aus einem elektrisch leitfähigen Material gebildeten Federblatt, das eine Grundplatte aufweist, die auf der Leiterplatte befestigt ist.

Die DE 39 06 859 C1 offenbart ein Bedienelement gemäaß dem Oberbegriff von Anspruch 1. Die Aufgabe der Erfindung besteht darin, einen beweglichen in einem Bedienelement gehaltenen Druckknopf bereitzustellen, der einfach aufgebaut und kostengünstig zu fertigen ist.

Eine weitere Aufgabe ist es, einen Druckknopf bereitzustellen, dessen elektronische Kontaktierung die Haptik des Druckknopfes nicht oder nur unwesentlich beeinflusst.

Die Aufgabe der Erfindung wird dadurch gelöst, dass ein die Kapazität bildender Kondensator aus einem an einer Innen- und/oder Außenseite einer dem Bediener zugewandten Oberfläche aufgebrachten metallischen Bereich gebildet ist und der metallische Bereich eine Elektrode des Kondensators bildet, die im Gehäuse elektrisch kontaktiert ist. Durch den erfindungsgemäßen Aufbau des Druckknopfes ist nun die Möglichkeit geschaffen, ein Bedienelement bereitzustellen, das einen einfachen Aufbau aufweist und somit kostengünstig herzustellen ist. Hierbei besteht der minimalisierte Aufwand zur Herstellung darin, dass lediglich eine Fläche am Druckknopf entweder metallisiert oder zum Beispiel mit einer metallischen Folie versehen wird, die wiederum elektronisch im Gehäuse des Bedienelementes kontaktiert ist. Durch das Aufbringen oder Befestigen eines metallischen Bereiches am Druckknopf wird mit minimalstem Aufwand und somit kostengünstig ein Druckknopf bereitgestellt, der mit einer Elektrode ausgestattet ist, die die erste Elektrode einer Kapazität bildet, wobei die zweite Elektrode durch den Bediener und vorzugsweise den Finger des Bedieners gebildet ist.

Erfindungsgemäaß ist ein weiterer Kondensator zwischen einer Seitenwand, die parallel zu einer Gehäusewand des Bedienelementes angeordnet ist, im Bedienelement vorgesehen. Hierdurch ist der emndungsgemäße Vorteil gegeben, dass die an der Oberfläche des Druckknopfes ausgebildete Elektrode berührungslos im Gehäuse kontaktiert ist. Dies wiederum bietet den Vorteil, dass die Haptik des Druckknopfes durch die Kondensatorelemente und deren elektrische Kontaktierung nicht beeinflusst wird.

Nachfolgend wird die Erfindung anhand eines Ausführungsbeispiels in Prinzipsskizzen näher erläutet. Es zeigt
- Figur 1: einen Schnitt durch ein erfindungsgemäß ausgebildetes Bedienelement mit einem Druckknopf in der Seitenansicht,
- Figur 2: ein Bedienungselement mit erfindungsgemäßem Druckknopf im Schnitt und in der Seitenansicht im gedrückten Zustand,
- Figur 3: einen schaltungstechnischen Aufbau einer speziellen Ausführung gemäß der Figuren 1 und 2 und
- Figur 4: einen Aufbau eines Bedienelementes mit mehreren erfindungsgemäßen Druckknöpfen ebenfalls in der Seitenansicht.

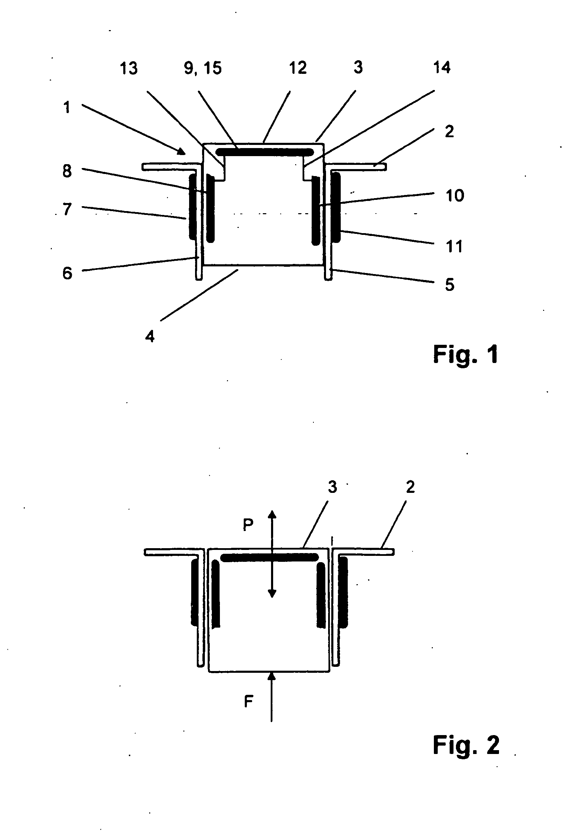

Die Figur 1 zeigt die Seitenansicht auf einen Teil eines Bedienelementes 1 eines Kraftfahrzeuges, wobei das Bedienelement 1 beispielsweise ein Taster für eine Klimaanlage, ein Gebläse, eine Sitzheizung, etc., ist. Das nur bereichsweise dargestellte Bedienelement besteht aus einem Gehäuse 2 und einem in dem Gehäuse 2 bewegbar angeordneten Druckknopf 3. Der Druckknopf ist beispielsweise im Gehäuse 2 mittels nicht dargestellter Führungen im Gehäuse 2 verschiebbar gegen eine Druckfeder oder die Federkraft eines unterhalb des Druckknopfs 3 angeordneten Tasters federnd befestigt, so dass der Druckknopf 3 in seiner in der Figur 1 dargestellten Stellung seine Ruheposition einnimmt. Im Gehäuse 2 ist eine Öffnung 4 enthalten, die in der Seitenansicht aus den Seitenwänden 5, 6 gebildet ist. Als schwarze Balken sind in der Figur 1 die Elektroden 7, 8, 9, 10, 11 der Kondensatoren dargestellt.

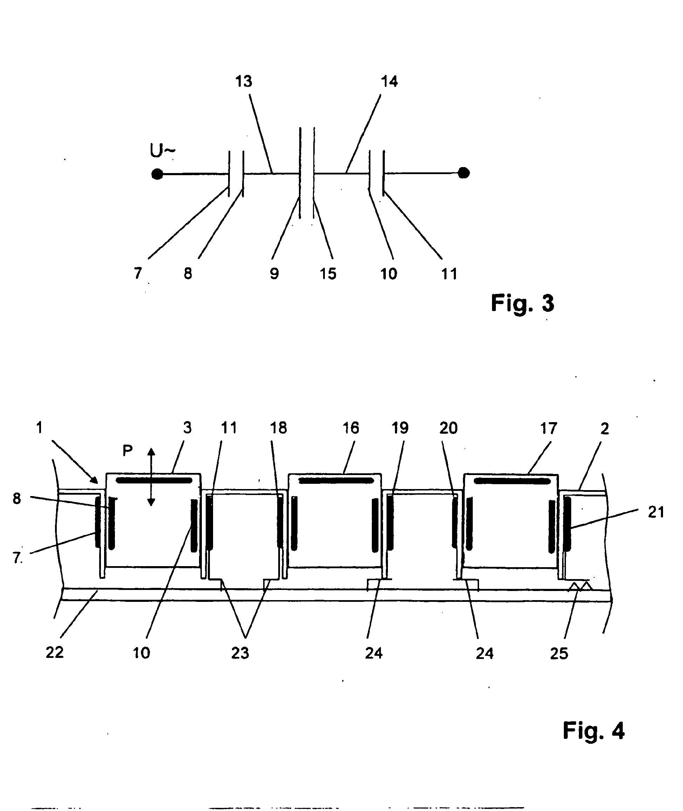

Hierbei bildet die Elektrode 9 an der Oberfläche 12 des Druckknopfes 3 die Elektrode, die eine Annäherung eines Fingers eines Bedieners detektiert und somit eine Funktion in der Elektronik des Kraftfahrzeuges auslöst. Die Elektrodepaare 7, 8 und 10, 11 bilden Koppelkondensatoren, mittels derer die Elektrode 9 berührungslos elektrisch kontaktiert ist. Hierzu sind die Elektroden 8, 10 über die Leitungen 13 mit der Elektrode 9 und über die Leitung 14 mit einer Elektrode 15 elektrisch verbunden. Sind an der Oberfläche zwei Elektroden 9, 15 ausgebildet, so ergibt sich beispielsweise das prinzipiell dargestellte Schaltbild der Figur 3.

Die Elektroden 7, 8, 9, 10, 11, 15 sind in diesem Ausführungsbeispiel jeweils an der Innenseite des Druckknopfs 3 und des Gehäuses 2 angeordnet. Es ist erfindungsgemäß aber ebenfalls vorstellar die Elektroden 7, 8, 9, 10, 11, 15 unmittelbar an den äußeren Oberflächen der Seitenwände 5, 6 des Gehäuses und/oder den inneren Oberflächen des Druckknopfes 3 zu positionieren.

Ein Vorteil der sich aus dem in der Figur 1 dargestellten Aufbau des erfindungsgemäßen Bedienelementes 1 ergibt, ist der, dass durch die sich gegenüberliegenden Elektroden 7, 8, 10, 11 Kapazitätsänderung kompensiert werden, wenn der Druckknopf 3 in einer nicht linearen Position in das Gehäuse 2 hineingeschoben wird. Die auf den gegenüberliegenden Seiten angeordneten Elektroden 7, 8 , 9, 10 kompensieren somit ein Kippen des Druck-knopfes 3 im Gehaüse 2.

Wird das erfindungsgemäße Bedienelement 1 nun an der Oberfläche 12 mittels eines Fingers in Richtung des Pfeils P in das Gehäuse 2 gegen die Kraft F einer Feder oder eines elektrischen Bauteils, wie beispielsweise ein Taster oder einer Kontaktmatte, hineingedrückt, so ergibt sich die Position des Druckknopfes 3, wie sie in der Figur 2 dargestellt ist. Der Druckknopf 3 und insbesondere der Kondensator 9 arbeitet annäherungssensitiv und berührungssensitiv, so ändert sich bereits beim Annähern an die Tastenoberfläche 12 die Kapazität und nimmt überproportional mit der Nähe der Taste 3 zu, beim Berühren des Druckknopfes 3 durch den Finger des Bedieners, ändert sich die elektrische Kapazität des Kondensators 9 wiederum, was elektronisch auswertbar ist. So ist das Erkennen der Annährung beispielsweise dann wichtig, wenn Bedienelemente 1 kontaktiert werden, die außerhalb des Sichtbereiches des Kraftfahrzeugführers liegen. Ein Beispiel für ein solches Bedienelement 1 ist die Sitzverstellung. Wird vom Bediener diese Sitzverstellung mit dem Finger kontaktiert, so ist dies mittels der Elektrode 9 als Änderung des kapazitiven Feldes des Kondensators 9, 15 detektierbar und mittels einer nachgeordneten Schaltung ist beispielsweise eine Visualisierung des Bedienelementes 1 in einem Display des Kraftfahrzeuges anzeigbar. Dem Bediener ist somit das Berühren oder die Auswahl des benötigten Bedienelementes 1 im Display anzeigbar. Dies bietet den erfindungsgemäßen Vorteil, dass die Auswahl des benötigten Bedienelementes 1 alleine aufgrund des Berührens auswählbar ist.

Wird nun der Druckknopf 3 in die in der Figur 2 dargestellte Position in das Gehäuse 2 hineingedrückt, so erfolgt eine zusätzliche Verschiebung der Kondensatorplatten 7, 8, 10, 11 aufgrund der mechanischen Kräfte und es erfolgt eine Kapazitätsänderung, die meßtechnisch auswertbar ist. So ist einerseits die Spannungsversorgung der Elektrode 9 des Oberflächenkondensators 9, 15 gewährleistet und zusätzlich kann eine dem Druckknopf 3 zugehörige Schaltfunktion überwacht oder ausgewertet werden.

Durch den erfindungsgemäßen Aufbau eines Druckknopfs 3 wird ein wesentlich robusterer gegen Stoß, Schock und Vibration sowie Altersverschleiß beständiger Druckknopf 3 bereitgestellt. Im Gegensatz zu herkömmlichen mittels fester Kontakte ausgeführter Druckknöpfe 3 unterliegt der erfindungsgemäße Druckknopf 3 keiner Kontakterrosion und/oder Korrosion. Die Figur 4 zeigt ein Bedienelement 1, in dem drei Druckknöpfe 3, 16, 17 in einem Gehäuse 2 nebeneinander angeordnet sind. Die Elektrode 7, 11, 18, 19, 20, 21 sind hierbei über verschiedenste elektrische Anschlüsse mit einer unterhalb der Druckknöpfe 3, 16, 17 angeordneten Leiterplatte 22 kontaktierbar. Vorstellbar ist eine Kontaktierung mittels Lötkontakten 23, mittels Einpresskontakten, wie beispielsweise Schleiffedern oder Schichtpotentiometem 24, oder aber mittels Nadeln 25.

Die Erfindung ermöglicht einen kompakten Aufbau eines Bedienelementes 1, wobei bewegliche Teile 3, 16, 17 nicht über Federkontakte oder Leitungen kontaktiert werden müssen. Die Haptik des Druckknopfes 3, 16, 17 wird somit nicht beeinflusst.

## Patentansprüche

1. Bedienelement für ein Kraftfahrzeug bestehend zumindest aus einem Druckknopf (3, 16, 17) und einem Gehäuse (2), wobei der auf kapazitiver Basis arbeitende, annäherungs- und berührungssensitive Druckknopf (3, 16, 17) im Gehäuse verschiebbar befestigt ist und ein die Kapazität bildender Kondensator (9, 15) aus einem an einer Innen- oder Außenseite einer dem Bediener zugewandten Oberfläche (12) aufgebrachten metallischen Bereich (9, 15) gebildet ist und der metallische Bereich (9, 15) eine Elektrode (9, 15) des Kondensators bildet, die im Gehäuse (2) elektrisch kontaktiert ist, **dadurch gekennzeichnet, dass** mindestens eine erste Elektrode (7, 10) an einer Innen- oder Außenseite einer zum Druckknopf (3, 16, 17) parallelen Wand (5, 6) einer Öffnung (4) des Gehäuses (2) vorhanden ist und eine zur Bildung eines Koppelkondensators (7, 8, 10, 11) zweite Elektrode (8, 10) am Druckkopf (3) vorhanden ist, wobei der Koppelkondensator (7, 8, 10, 11) mit dem an der Oberfläche (12) vorhandenen Kondensator (9, 15) in Reihe geschaltet ist.

2. Bedienelement nach Anspruch 1, **dadurch gekennzeichnet, dass** der Kondensator (9, 15) aus zwei an der Innen- oder Außenseite aufgebrachten Bereichen (9, 15), die jeweils eine Elektrode (9, 15) des Kondensators bilden, gebildet ist.

3. Bedienelement nach einem der Ansprüche 1 und 2, **dadurch gekennzeichnet, dass** jeweils ein Koppelkondensator (7, 8, 10, 11) an gegenüberliegenden Seiten des Druckknopfes (3) vorhanden ist.

4. Bedienelement nach einem der Ansprüche 1 bis 3, **dadurch gekennzeichnet, dass** die Elektrode (7, 8, 9, 10, 11) aus einer mittels eines PVD-Verfahrens aufgebrachten metallischen Schicht (7, 8, 9, 10, 11) gebildet ist.

## Claims

1. Control element for a motor vehicle, consisting at least of one push button (3, 16, 17) and a housing (2), wherein the proximity and touch sensitive push button (3, 16, 17) operating on a capacitive basis is mounted displaceably in the housing, and a capacitor (9, 15) forming the capacity is formed of a metallic region (9, 15) applied to an inside or outside of a surface (12) facing the operator, and the metallic region (9, 15) forms an electrode (9, 15) of the capacitor, which electrode is electrically contacted in the housing (2), **characterised in that** at least a first electrode (7, 10) is provided on an inside or outside of a wall (5, 6), which is parallel to the push button (3, 16, 17), of an opening (4) of the housing (2), and a second electrode (8, 10) is provided on the push button (3) for forming a coupling capacitor (7, 8, 10, 11), said coupling capacitor (7, 8, 10, 11) being connected in series with the capacitor (9, 15) provided on the surface (12).

2. Control element according to claim 1, **characterised in that** the capacitor (9, 15) is formed from two regions (9, 15) applied to the inside or outside, each of which forms an electrode (9, 15) of the capacitor.

3. Control element according to any one of the claims 1 and 2, **characterised in that** one coupling capacitor (7, 8, 10, 11), respectively, is provided on opposite sides of the push button (3).

4. Control element according to any one of the claims 1 to 3, **characterised in that** the electrode (7, 8, 9, 10, 11) is formed from a metallic layer (7, 8, 9, 10, 11) applied by means of a PVD process.

## Revendications

1. Elément de commande pour un véhicule automobile, se composant au moins d'un bouton-poussoir (3, 16, 17) et d'un boîtier (2), ledit bouton-poussoir (3, 16, 17) réactif à l'approche et au toucher et travaillant à base capacitive étant fixé dans ledit boîtier de manière à pouvoir être déplacé, et un condensateur (9, 15) qui forme la capacité étant formé par une zone métallique (9, 15) appliquée sur une face intérieure ou extérieure d'une surface (12) tournée vers l'opérateur, et ladite zone métallique (9, 15) formant une électrode (9, 15) du condensateur qui est contactée électriquement dans ledit boîtier (2), **caractérisé par le fait qu'**au moins une première électrode (7, 10) est située sur une face intérieure ou extérieure d'une paroi (5, 6) d'une ouverture (4) du boîtier (2), qui (ladite paroi) s'étend parallèlement audit bouton-poussoir (3, 16, 17) et qu' une deuxième électrode (8, 10) est située sur ledit bouton-poussoir (3) pour former un condensateur de couplage (7, 8, 10, 11), ledit condensateur de couplage (7, 8, 10, 11) étant monté en série avec le condensateur (9, 15) existant sur ladite surface (12).

2. Elément de commande selon la revendication 1, **caractérisé par le fait que** ledit condensateur (9, 15) est formé par deux zones (9, 15) appliquées sur la face intérieure ou extérieure qui forment chacune une électrode (9, 15) du condensateur.

3. Elément de commande selon l'une quelconque des revendications 1 et 2, **caractérisé par le fait que** respectivement un condensateur de couplage (7, 8, 10, 11) est présent de côtés opposés dudit bouton-poussoir (3).

4. Elément de commande selon l'une quelconque des revendications 1 à 3, **caractérisé par le fait que** ladite électrode (7, 8, 9, 10, 11) est formée par une couche métallique (7, 8, 9, 10, 11) déposée au moyen d'un procédé PVD.
